(19) Europäisches Patentamt
European Patent Office
Office européen des brevets

(11) **EP 1 595 624 B1**

(12) **EUROPEAN PATENT SPECIFICATION**

(45) Date of publication and mention
of the grant of the patent:
**17.06.2009 Bulletin 2009/25**

(51) Int Cl.:
***B22F 3/06*** (2006.01)

(21) Application number: **03786315.6**

(86) International application number:
**PCT/JP2003/016742**

(22) Date of filing: **25.12.2003**

(87) International publication number:
**WO 2004/060593 (22.07.2004 Gazette 2004/30)**

(54) **CENTRIFUGAL SINTERING SYSTEM**

ZENTRIFUGALSINTERSYSTEM

SYSTEME DE FRITTAGE CENTRIFUGE

(84) Designated Contracting States:
**AT BE BG CH CY CZ DE DK EE ES FI FR GB GR HU IE IT LI LU MC NL PT RO SE SI SK TR**

(30) Priority: **27.12.2002 JP 2002382579**

(43) Date of publication of application:
**16.11.2005 Bulletin 2005/46**

(73) Proprietors:
• **National Institute of Advanced Industrial Science and Technology**
**Tokyo 100-8921 (JP)**
• **SINTO V-CERAX, LTD.**
**Toyokawa-shi,**
**Aichi 442-8505 (JP)**

(72) Inventors:
• **WATARI, Koji,**
**c/o AIST Chubu**
**Moriyama-ku,**
**Nagoya-shi,**
**Aichi 463-8560 (JP)**

• **KINEMUCHI, Yoshiaki,**
**c/o AIST Chubu**
**Moriyama-ku,**
**Nagoya-shi,**
**Aichi 463-8560 (JP)**
• **UCHIMURA, Shoji**
**Nagoya-shi, Aichi 458-0833 (JP)**
• **ISHIGURO, Hirohide**
**Gamagori-shi, Aichi 443-0038 (JP)**
• **MORIMITSU, Hideki**
**Shinshiro-shi, Aichi 441-1346 (JP)**

(74) Representative: **Ebner von Eschenbach, Jennifer Ladas & Parry LLP**
**Dachauerstrasse 37**
**80335 München (DE)**

(56) References cited:
**EP-A1- 1 070 686      EP-A2- 1 219 580**
**DE-A1- 2 412 637      JP-A- 9 221 367**
**JP-A- 10 087 370      JP-A- 10 212 182**
**JP-A- 11 092 294**

**Description**

BACKGROUND OF THE INVENTION

1. Field of the Invention

The present invention relates to a centrifugal sintering system for obtaining a ceramic or metal sintered body or a ceramic film by drying and/or sintering a molded body of ceramics or metal powder or a ceramic precursor film in a centrifugal field, more particularly relates to a ceramic member for a centrifugal sintering system which allows a compact sintered body of ceramic or metal or a compact ceramic film to be obtained by drying and/or sintering of a molded body of ceramics or metal powder or a ceramic precursor film while applying centrifugal force to these by means of high-speed rotation of a sample holder, and to a centrifugal sintering system equipped with this ceramic member. The present invention is useful in that it provides a rotor for high-temperature, high-speed rotation of a sample holder, a shaft and a sample holder for use in a centrifugal sintering system.

2. Description of the Related Art

In general, the centrifugal separation system is a typical example of a practical device applying centrifugal force. As high-temperature heating means for sintering purposes, high frequency induction heating and dielectric heating are practical applications capable of rapid heating so as to allow control of atmospheric conditions by means of vacuum or gas replacement or the like. Moreover, in recent years ceramics and the like which are capable of reducing thermal expansion and providing mechanic strength, excellent heat resistance and abrasion resistance as well as low relative density and weight have been applied as materials for gas turbine blades and other typical parts of ultraprecise rotating bodies used in high-temperature atmospheres.

Meanwhile, a sintering method and system have been proposed for producing a sintered body by heating and baking a sample while applying centrifugal force to that sample (see Japanese Patent Application Laid-open No. 2002-193680/2002). In general, in this sort of method the centrifugal force generated in the sample is determined by the rotational frequency of the rotor, the diameter to the sample and the relative density of the sample, and is indicated by the following formula:

$$CF = 11.18 \times (N/1000)^2 \times R \qquad\qquad (1-1)$$

where CF is the generated centrifugal force (G), N is the rotational frequency per minute (min⁻¹), and R is the distance from the center of the rotor to the sample. Since centrifugal force is proportional to the square of the rotational frequency and the distance from the center of the rotor to the sample, the greater the rotational frequency of the rotor the greater the centrifugal force it generates, but the greater the internal stress generated within the rotor itself, which presents a danger that the rotor itself will fail. Table 1 shows the relationship between rotational frequency and centrifugal force with the distance between the center of the rotor and the sample given as 8 cm. For these reasons, it is important to develop for the rotor part drives capable of withstanding high-speed rotation and rotors with a large distance between the center of the rotor and the sample or in other words large-diameter rotors, and consequently it is important to develop new members which will allow these to be developed.

Table 1

| Rotational frequency (min⁻¹) | 5,000 | 7,000 | 10,000 | 30,000 | 50,000 | 70,000 |
|---|---|---|---|---|---|---|
| Centrifugal force ($\times$ G) | 2,236 | 4,382 | 8,944 | 80,496 | 223,600 | 438,256 |

Moreover, the following two systems are used for turning the rotating shaft at ultrahigh speeds: (1) the rigid shaft system, wherein the flexural critical speed of the rotating shaft is set as high as possible, and the shaft is used below that flexural critical speed, and (2) the elastic shaft system, wherein the rotating shaft is used above its flexural critical speed. Of these, in the case of the rigid shaft system it is necessary to widen the outer diameter of the rotating shaft and the like in order to increase the flexural rigidity of the rotating shaft. However, making the rotating shaft larger increases the circumferential speed of the bearing, and there are limits on the lubricating conditions.

In the case of the elastic shaft system, on the other hand, a structure is adopted in which the rotating shaft has a narrow diameter so that the flexural critical speed of the shaft is relatively low, rotation is increased without controlling flexure, and the critical speed is exceeded so that the rotating shaft is used up to a high-speed rotation range beyond the flexural critical speed. Because the rotating shaft of the aforementioned sintering system is used in high-temperature atmospheres, if a ceramic shaft is adopted, because ceramics is a brittle material, increasing the rotational speed of this rotating shaft above the flexural critical speed is difficult as in the case of a rigid shaft system because the flexural tolerance of the material is low. Consequently, the problem in this system is that the rotational speed of the rotating shaft is limited to speeds below the flexural critical speed.

A centrifugal sintering system of the above mentioned type is known from EP 1 219 580.

SUMMARY OF THE INVENTION

In light of the aforementioned circumstances and problems of prior art, it is an object of the present invention to provide a ceramic member for a centrifugal sintering system which is a member consisting of a rotor, a shaft and a sample holder to be used in a system capable of imparting a centrifugal force field and a temperature field to a molded body of ceramic or metal powder or a ceramic precursor film, wherein the shaft and the rotor for turning the sample holder are durable under conditions in which atmospheric temperatures on the level of 1200°C are applied, and to provide a centrifugal sintering system which allows a sample to be indirectly heated using induction heating means or dielectric heating means. The invention is defined in the claims.

In order to solve the aforementioned problems, the present invention consists of the following technical means.

(1) A ceramic member for a centrifugal sintering device, which is a member consisting of a rotor, a shaft and a sample holder to be used in a centrifugal sintering device imparting a centrifugal force field and a temperature field to a molded body of ceramics or metal powder or a ceramic precursor film, wherein the rotor which turns the sample holder, the shaft and/or the sample holder are composed of ceramics, and wherein the rotor, shaft and sample holder undergo no thermal deformation and are not damaged by thermal stress when subjected to centrifugal force of 10 to 700,000 G under conditions of atmospheric temperatures of 300 to 1200°C.

(2) The ceramic member according to (1) above, wherein the rotor which turns said sample holder and the shaft are composed of silicon nitride or silicon carbide ceramics.

(3) The ceramic member according to (1) or (2) above, wherein the rotor which turns said sample holder is composed of conductive silicon carbide ceramics, and the sample is heated indirectly by selectively causing only the rotor to self heat using induction heating means.

(4) The ceramic member according to (1) or (2) above, wherein said sample holder is composed of a material having a large dielectric loss, and the sample is heated indirectly by selectively heating only the sample holder using dielectric heating means.

(5) The ceramic member according to (4) above, wherein said sample holder is composed of conductive silicon carbide ceramics.

(6) A centrifugal sintering system comprising the ceramic member according to any of (1) through (5) above as a constituent element.

Next, the present invention is explained in more detail.

As described above, the present invention is a member consisting of a rotor, a shaft and a sample holder to be used in a centrifugal sintering device imparting a centrifugal force field and a temperature field to a molded body of ceramics or metal powder or a ceramic precursor film, wherein the rotor which turns the sample holder, the shaft and/or the sample holder are composed of ceramics, and wherein these undergo no thermal deformation and are not damaged by thermal stress when subjected to centrifugal force of 10 to 700,000 G under conditions of atmospheric temperatures of 300 to 1200°C. According to the inventors' research, systems which rotate at high speeds in high-temperature atmospheres need to fulfill the following conditions. That is, (1) the material of the rotor must be one which has low thermal expansion, excellent mechanical strength and heat resistance and a low relative density, and which can be made lightweight, (2) the rotor must be of a disc type with low air resistance which can withstand high-speed rotation, and the distance between the center of the rotor and the sample must be large, or in other words the rotor must have a large diameter, (3) the shaft must be of a material having low thermal expansion, excellent mechanical strength and heat resistance, low thermal conductivity and excellent thermal insulation, (4) a rigid shaft system must be adopted which allows the flexural critical speed of the shaft to be set as high as possible, with the shaft being used below this flexural critical speed, and (5) rapid heating by means of a high-frequency inductive heating or dielectric heating system is effective for the heating means, and in particular it is necessary that the rotor and sample holder be of a material which is capable of selective, local heating.

As a result of study and research aimed at solving these problems, it was found to be vital to adopt the following composition. That is, it is vital (1) to achieve a light-weight rotor by using as the rotor material a material with a low specific density and a high strength at elevated temperatures under atmospheric temperature conditions on the level of 1200°C or less, (2) to ensure thermal insulation between the rotor and the bearing by using as the shaft material a material with low thermal conductivity and high strength at elevated temperatures under atmospheric temperature conditions on the level of 1200°C or less, (3) to use as an excellent material for the heating means an electrically conductive material capable of induction heating or a material with a high dielectric loss capable of dielectric heating, (4) that the rotor be of a disc form without projections, which is a form with hydrodynamically little air resistance, and, and (5) that the sample holder be contained within a disc so as to allow efficient heating and cooling as well as easy handling, and that a material be used which allows the sample holder alone to be selectively heated.

Considering all these conditions collectively, it was found that the aforementioned problem of durability in atmospheres on the level of 1200°C could be resolved by adopting by preference as specific materials silicon carbide ceramics for the rotor which turns at high temperatures and speeds and the sample holder for example, or silicon nitride ceramics for the shaft.

That is, the present invention is **characterized in that** the shaft and the rotor which turns at high temperatures and speeds are composed of silicon nitride or silicon carbide so that they will not undergo thermal deformation or be damaged by thermal stress when subjected to 10 to 700,000 G of centrifugal force under conditions of atmospheric temperatures of 300 to 1200°C. Moreover, the present invention is **characterized in that** the rotor which turns at high temperatures and speeds and the sample holder are composed of silicon carbide ceramics and the shaft is composed of silicon nitride ceramics, and induction heating means or dielectric heating means is used to cause the rotor or sample holder to self heat, thus selectively heating the sample.

Examples of the silicon nitride ceramics used in the present invention include silicon nitride sintered bodies having added sintering assistants such as alumina or yttria, and sialon sintered bodies having added alumina, aluminum nitride or the like. Likewise, examples of silicon carbide ceramics include silicon carbide sintered bodies having added sintering assistants such as boron or carbon. Examples of conductive silicon carbide ceramics include for example hot-press sintered silicon carbide sintered bodies using high-purity silicon carbide raw materials and having trace amounts of added isoelectric substances. Moreover, examples of materials with high dielectric loss include isoelectric silicon carbide, zirconia and the like. However, these are not limitations as long as the characteristics shown in Table 2 are present.

Next, to explain the method of preparing the rotor, shaft and sample holder, the starting material and sintering assistant are mixed and ground, and a molding assistant is added to the slurry which is then dried with a spray dryer and pelletized to prepare the press material. Next, a disc shape and rod shape, respectively, are molded by the isostatic pressure molding method, the molding assistant is degreased, and the silicon nitride is sintered at normal pressure and the silicon carbide hot press sintered to obtain raw material. Next, a rotor, shaft and sample holder of the specified shapes are prepared by machining.

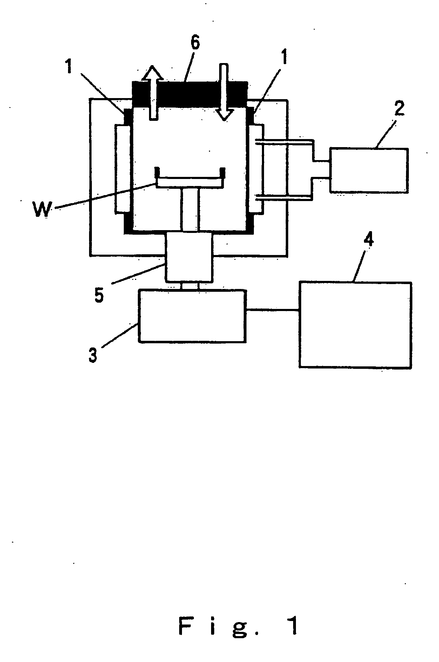

Examples of the centrifugal sintering system used in the present invention include a sintering system (Figure 1) equipped with a work part having a sample plate (sample holder) capable of high-speed rotation, a heating part which heats the work part, a temperature control part which controls the heating temperature, a rotating part (rotor and shaft) which rotates the work, a rotational speed control part which controls the rotational speed, a vacuum magnetic seal bearing, and a lid for sealing. Apart from these, however, others having effectively the same means and function could be used in the same way. In the present invention, the rotor and shaft making up the rotating part in the aforementioned sintering system are composed of the aforementioned silicon nitride and silicon carbide ceramics, or else the aforementioned rotor is composed of conductive silicon carbide ceramics and the aforementioned sample holder is composed of a material with a large dielectric loss such as for example conductive silicon carbide ceramics.

In the present invention, because the aforementioned composition is adopted it is possible to indirectly heat a sample by selectively heating only the rotor or the sample holder using induction heating means, thus greatly improving energy efficiency in the sintering step. Moreover, because the aforementioned rotor and shaft are composed of the aforementioned silicon nitride or silicon carbide ceramics, they can be rotated at higher speeds and with a higher safety factor than stainless steel rotors and shafts without undergoing thermal deformation or being damaged by thermal stress even when subjected to centrifugal force of 10 to 700,000 G under atmospheric temperature conditions of 300 to 1200°C. For example, an unanticipated benefit was that while in the case of stainless steel the rotational speed cannot exceed 10,000 min$^{-1}$, silicon nitride ceramics have a high safety factor even at rotational speeds above 10,000 min$^{-1}$.

Moreover, as shown in the test examples below, it was found that silicon nitride and silicon carbide ceramics are particularly desirable from the standpoint of breaking strength and lightness, and the safety of the shaft and the resonance frequency are increased. By using the rotor for turning the sample holder, the shaft and the sample holder of the present invention it is possible to achieve a centrifugal sintering system capable of applying a centrifugal force field of 10 to 700,000 G and a temperature field of 300 to 1200°C. In the present invention, there are no particular limitations on the heating means, but when the rotor and/or sample holder are composed of conductive silicon carbide ceramics, induction heating means or dielectric heating means is adopted. In this case, there are no particular limitations on the specific composition of this heating means, and appropriate means and methods can be adopted.

The sample holder needs to have a structure which facilitates removal of the sample and which does not move in response to load from centrifugal force. Moreover, because the sample holder is subjected to centrifugal force its weight needs to be as light as possible, and the weight of each holder needs to be fixed so that rotational oscillation will not be generated by eccentricities. Examples include a system in which the sample holder is dropped into a pocket hole on the outside of the rotor, or one in which the sample holder is dropped into the rotor so that the sample can be set without a vis, but these are not limitations.

Next, the present invention is explained in detail based on test examples.

Various stainless and ceramic materials were evaluated as materials for the rotor and shaft. The properties of the various materials are shown in Table 2. As materials for the rotor and shaft, as shown in Table 2, silicon nitride and silicon carbide exhibit more favorable relative density, room temperature strength, high-temperature strength, fracture toughness, thermal shock resistance and the like than other ceramics.

Table 2

| Material | Relative density | Young's modulus | Room-temperature strength | High-temperature strength | High-temperature strength | Fracture toughness | Thermal shock resistance | Electrical resistance | Thermal conductivity |
|---|---|---|---|---|---|---|---|---|---|
| | $kg/cm^3$ | $kg/cm^2$ x $10^6$ | $kg/cm^2$ | $kg/cm^2$ (800°C) | $kg/cm^2$ (1200°C) | $MPam^{1/2}$ | °C | $\Omega$-cm | cal·cm/cm²·sec °C |
| Stainless | 8.0 | 2.0 | 2700 | 1300 | <220 | - | - | 0.079 | 0.04 |
| Hastelloy | 8.2 | 2.1 | 3630 | 1830 | <560 | - | - | 0.118 | 0.02 |
| Silicon nitride | 3.2 | 3.0 | 4900 | 4200 | 3900 | 6 | 650 | $>10^{14}$ | 0.07 |
| Silicon carbide | 2.3 | 4.4 | 4600 | 4600 | 4600 | 3 | 500 | 0.0006 | 0.20 |
| Zirconia | 6.1 | 2.1 | 9800 | 4900 | 1100 | 10 | 350 | $>10^{14}$ | 0.009 |
| Alumina | 3.9 | 3.5 | 3300 | 3000 | 2500 | 3 | 200 | $>10^{14}$ | 0.06 |
| Sialon | 3.2 | 3.3 | 8000 | 5000 | 4500 | 5 | 700 | $>10^{14}$ | 0.06 |

In order to evaluate the materials of the rotor and shaft, (1) material selection for the rotor part, (2) calculation of shaft strength and selection of material, dimensions and shape, (3) calculation of resonance frequency and (4) favorable configuration were investigated.

(1) Material selection for the rotor part

The strength of the rotor is thought to correspond to the maximum tensile stress generated as tensile stress in the radial direction of the rotor ($\sigma_{rmax}$) and the maximum tensile stress generated circumferentially by rotation ($\sigma\theta_{max}$), which were calculated as follows. That is, the $\sigma_{max}$ occurring as tensile stress in the radial direction of the rotor is expressed by the following formula:

$$\sigma_{rmax} = (\gamma \cdot \omega^2/8g) \times (3 + \upsilon) \times (b - a)^2 \qquad (1-2)$$

while the $\sigma\theta_{max}$ generated circumferentially by rotation is expressed by the following formula:

$$\sigma\theta_{max} = (\gamma \cdot \omega^2/4g) \times \{(3 + \upsilon) \times b^2 + (1 - \upsilon) \times a^2\} \quad (1-3)$$

where $\gamma$ is the relative density of the material (kgf/cm³), $\omega$ is the angular velocity (rad/sec), $\upsilon$ is the Poisson's ratio of the material, a is the inside diameter of the rotor (cm), b is the outside diameter of the rotor (cm), and g is the gravitational acceleration (cm/sec²).

Next, an investigation of stainless steel is given as one example. With the rotational frequency of the rotor given as 15,000 min⁻¹, the inside diameter a of the rotor as 0.6 cm, the outside diameter b of the rotor as 9 cm, the $\gamma$ of stainless as 0.00793 kgf/cm³ and $\upsilon$ as 0.3, the $\sigma_{max}$ and $\sigma\theta_{max}$ generated in a stainless steel rotor were calculated as 581 and 1334 kgf/cm², respectively. As shown in Table 2, since the yield strength of stainless at 800°C is 1300 kgf/cm² the $\sigma\theta_{max}$ value obtained exceeds the yield strength of stainless, indicating that a stainless steel rotor is not suited to high-speed rotation (15,000 min⁻¹) at high temperatures (800°C).

The investigation of silicon nitride is given next as another example. Given a $\gamma$ value of 0.0032 kgf/cm³ and a $\upsilon$ value of 0.2 for silicon nitride, $\sigma_{rmax}$ is 227 kgf/cm² and $\sigma\theta_{max}$ is 522.1 kgf/cm².

As shown in Table 2, the tensile stress of silicon nitride is 4200 kgf/cm², which is sufficiently larger than both the $\sigma_{rmax}$ and $\sigma\theta_{max}$. Consequently, it is shown that a silicon nitride rotor is suited to high-speed rotation (15,000 min⁻¹) at high temperatures (800°C).

The safety factor indicates the limit at which a member does not deform, and the size of this value is an indicator for selecting the material of a member. The safety factor is expressed as follows based on the maximum generated tensile stress and the particular yield strength of the material.

(For Stainless)

Safety factor S = Material yield strength/Maximum

generated tensile stress                                      (1-4)

(For silicon nitride)

Safety factor S = Allowable tensile stress/Maximum

generated tensile stress                                      (1-5)

The $\sigma_{rmax}$ and $\sigma\theta_{max}$ generated in silicon nitride and stainless steel rotors when the rotational speed was varied were calculated based on formulae (1-2) and (1-3), and the safety factors were calculated from formulae (1-4) and (1-5) above to investigate safety. The yield strength of stainless steel at 800°C was given as 1300 kgf/cm² based on Table 2. On the other hand, because ceramics is a brittle material with almost no deformability, tensile breaking strength was used instead of yield strength. The breaking strength of silicon nitride at 800°C was given as 4200 kgf/cm² based on Table 2.

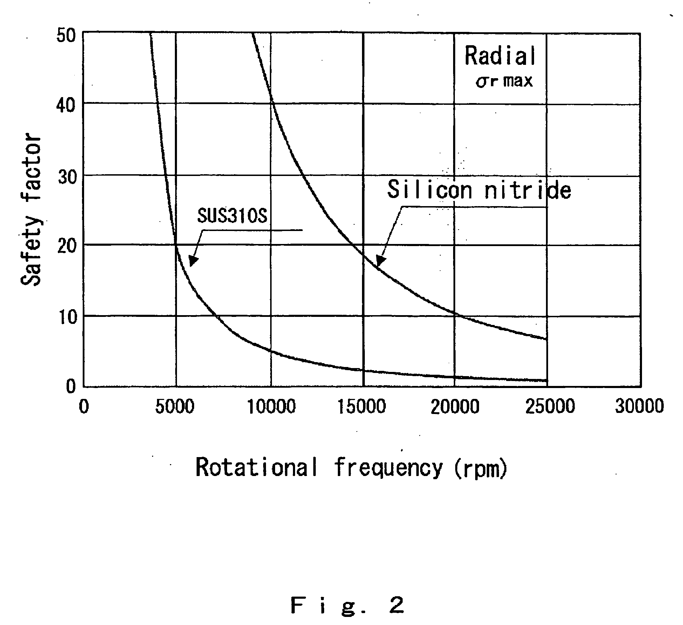

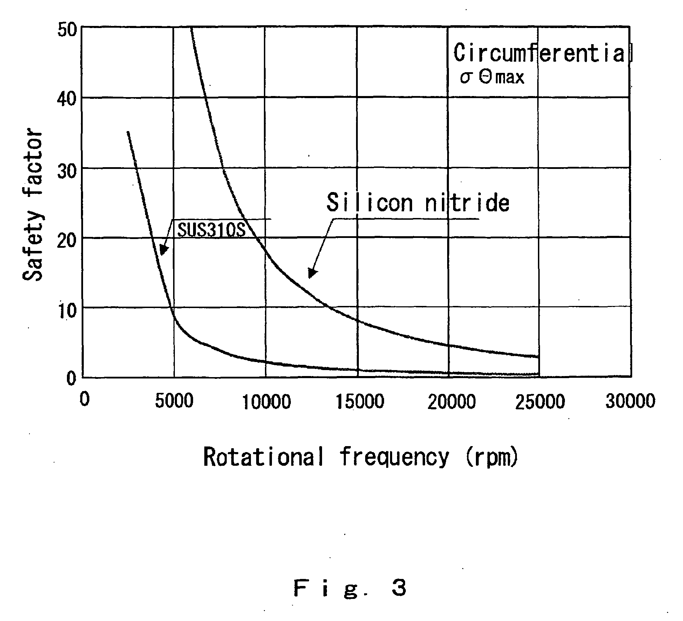

Figures 2 and 3 show the relationships between the safety factors and rotational speeds of stainless steel and silicon nitride rotors radially and circumferentially at 800°C. Within the specified range of rotational speeds, silicon nitride exhibited a greater safety factor than stainless. In particular, while silicon nitride exhibited high values of about 7 radially and 3 circumferentially during high-speed rotation at a speed of 25,000 min⁻¹, stainless exhibited low values of about 2 radially and 1 circumferentially. This indicates that a silicon nitride rotor is capable of high speed rotation with a higher safety factor than a stainless rotor, and even over 10,000 min⁻¹ the silicon nitride rotor was very safe. Meanwhile, the stainless rotor maintained a safety factor up to a rotational speed of 10,000 min⁻¹ but not above that, showing that the stainless rotor can only be applied up to a rotational speed of 10,000 min⁻¹.

(2) Calculating shaft strength and selecting material, dimensions and shape

The formulae for calculating shaft strength are as follows:

Centrifugal force (kgf) on the shaft

$$F = \{W \times (\delta + \varepsilon)/g\} \times \omega^2 \qquad (1-6)$$

Axial flexure from centrifugal force

$$\delta = F \cdot L^3/3E \cdot I \qquad (1-7)$$

Maximum tensile stress (kgf/cm²) generated in the shaft

$$\sigma_{max} = F \cdot L/Z \qquad (1-8)$$

where W is the rotor weight (kgf), $\delta$ is axial flexure (cm), $\varepsilon$ is rotor eccentricity (cm), $\omega$ is angular velocity (rad/sec), L is shaft length (length from fixed end) (cm), E is Young's modulus, I is the geometrical moment of inertia (cm⁴), and Z is the section modulus (cm³).

The stress generated in a stainless shaft was investigated. Judging from the results for safety factor above (1), it is important that the rotational frequency in the case of a stainless rotor not exceed 10,000 min⁻¹. Consequently, calculation was done with a rotational speed of 10,000 min⁻¹ using a rotor of the form shown in Figure 1. Rotor weight W was given as 4.06 kgf, rotor eccentricity $\varepsilon$ as 0.01 cm, shaft diameter d as 3 cm, shaft length L as 12 cm, Young's modulus E as 2,000,000 kgf/cm², geometrical moment of inertia I as 3.97 cm⁴ and section modulus Z as 2.65 cm³.

I was given as 3.97 because I = πd⁴/64. The value of 2.65 was given for Z because Z = πd3/32. Calculating based on these values, the centrifugal force F on the shaft was 66,250 kgf • cm/sec², the axial flexure $\delta$ was 49 μm, and the maximum tensile stress $\sigma_{max}$ generated in the shaft was 306 kgf/cm². Based on the resulting maximum tensile stress, the yield strength of stainless at 800°C was 1300 kgf/cm² based on Table 2 and the safety factor was calculated as 4.2. A similar strength calculation was performed for silicon nitride. Weight W was given as 1.62 kgf, rotor eccentricity $\varepsilon$ as 0.01 cm, shaft diameter as 3 cm, shaft length L as 12 cm, Young's modulus E as 3,000,000 kgf/cm², geometrical moment of inertia I as 3.97 cm⁴, and section modulus Z as 2.65 cm³. The rotational speed was given as 10,000 min⁻¹ for purposes of comparison with stainless. The calculated centrifugal force F on the shaft was 19,475 kgf • cm/sec², the axial flexure $\delta$ was 10 μm, and the maximum tensile stress σmax occurring in the shaft was 90 kgf/cm². In this case, the safety factor at 800°C calculated based on the maximum tensile stress was 4.67. By changing the material while keeping the same axial diameter, the weight was reduced 2.5 times, while the Young's modulus was increased 1.5 times. The ultimate safety factor for silicon nitride was about 11 times that of stainless, indicating a dramatic improvement in reliability.

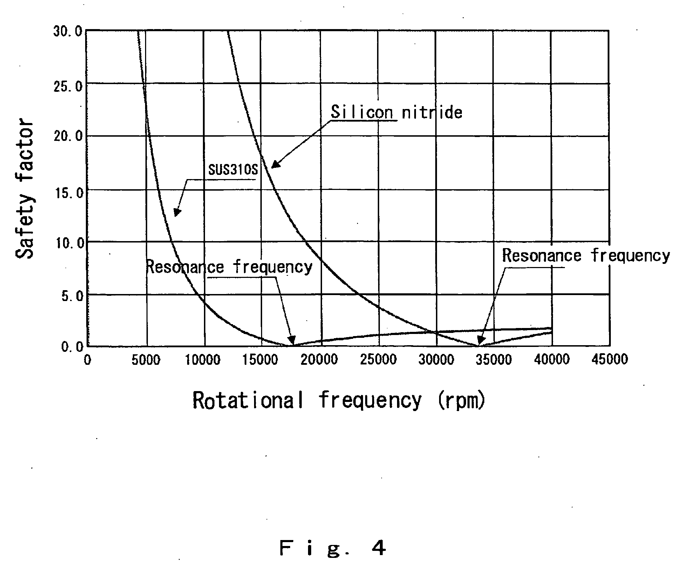

Figure 4 shows the strength of the rotating shafts at a temperature of 800°C, or in other words the relationship between the rotational frequencies and safety factors of the stainless and silicon nitride rotating shafts. Within the specified range of rotational frequencies the silicon nitride exhibited higher safety factor values than the stainless. In particular, the safety factor values indicated numerically adequate reliability for the silicon nitride rotor and shaft when used below the resonance frequency. The dimensions of the silicon nitride and stainless rotors and shafts were then determined based on these results. The rotating shaft is fixed on a bearing, and the larger the bore diameter the more rigid the rotating axis and the greater the safety factor, but this increases the circumferential speed of the bearing, so there are limits considering the life of the bearing. In this case, the shaft diameter was given as 3 cm for an allowable rotational speed of 35,000 min$^{-1}$ under grease lubricating conditions as the lubricating system.

(3) Calculating the resonance frequency

The formula for calculating the resonance frequency is shown below.

Resonance frequency (min$^{-1}$)

$$n = (30/\pi) \times (3E \cdot I \cdot g/L^3 \cdot W)^{1/2} \qquad\qquad (1-9)$$

where W is the rotor weight (kgf), L is the shaft length (length from the fixed end) (cm), E is the Young's modulus (kgf/cm$^2$), I is the geometrical moment of inertia (cm$^4$), and g is the gravitational acceleration (cm/sec$^2$). Based on the formula above, the resonance frequency was calculated using a stainless steel rotor and a silicon nitride rotor. The weight W of the stainless rotor was given as 4.06 kgf, the stainless shaft diameter d as 3 cm, the shaft length L as 12 cm, the Young's modulus E as 2,000,000 kgf/cm$^2$, the geometrical moment of inertia I as 3.97 cm$^4$, and the gravitational acceleration g as 980 cm/sec$^2$. The geometrical moment of inertia I was calculated here as $I = \pi d^4/64$. The resonance frequency n was then calculated as 17,440 min$^{-1}$.

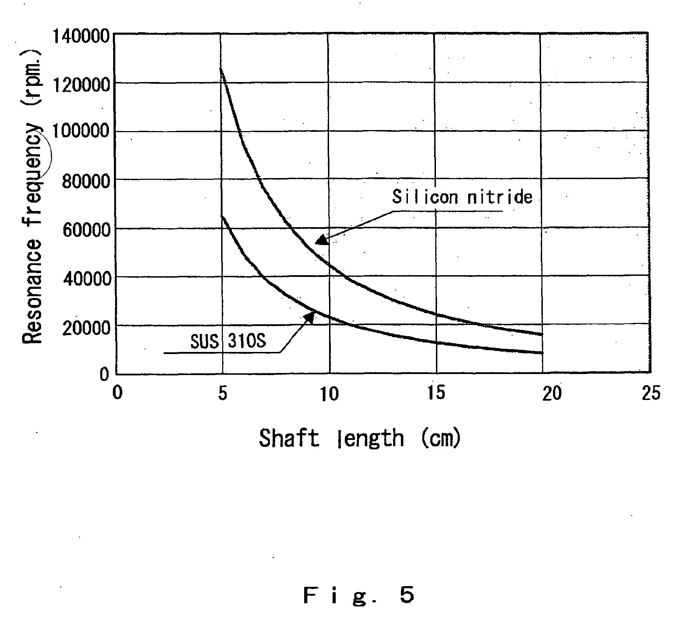

On the other hand, the weight W of the silicon nitride rotor was given as 1.62 kgf, the silicon nitride shaft diameter as 3 cm, the shaft length L as 12 cm, the Young's modulus E as 3,000,000 kgf/cm$^2$, and the geometrical moment of inertia I as 3.97cm$^4$. The geometrical moment of inertia I was calculated here as $I = \pi d^4/64$. The resonance frequency n was then calculated as 33,790 min$^{-1}$. Values for resonance frequency with varying shaft lengths if both stainless and silicon nitride are shown in Figure 5. The resonance frequency rose geometrically as the shaft length increased, and the values for silicon nitride were double those for stainless.

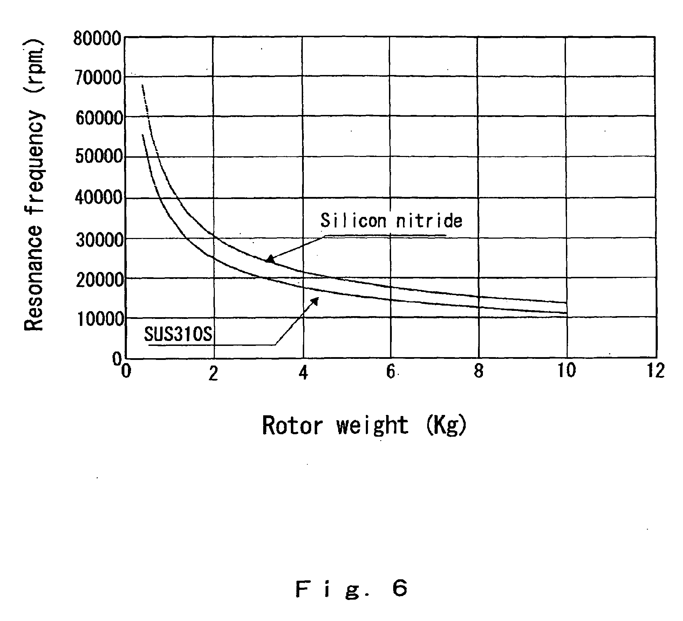

Figure 6 shows resonance frequency values for stainless and silicon nitride using different rotor weights. The resonance frequency rose geometrically as the rotor weight was decreased, but the effect was not as great as that of shaft length. Moreover, because silicon nitride has a low relative density, the resonance frequency is higher. These results indicate that a structure with a short shaft length and a rotor which is as light as possible is effective. It is possible to increase the resonance frequency by adopting a rotating shaft of silicon nitride. However, silicon nitride is a brittle material, and because of the danger of sudden breakage in the resonance frequency range it is an indispensable condition that it be used below the resonance frequency. The discussion of ceramic materials has focussed here on silicon nitride, but when silicon carbide was studied, it was found that silicon carbide has equivalent material properties, and can be expected to have equivalent effects.

(4) Favorable configuration

From the research results the configuration of the rotor part was found to be as follows. That is, a silicon nitride rotor is capable of higher speed rotation with a higher safety factor than a stainless rotor, and a silicon nitride rotor is very safe even above 10,000 min$^{-1}$. In the case of the stainless rotor, the rotational frequency must not exceed 10,000 min$^{-1}$. Regarding the configuration of the shaft, the research results revealed the following. That is, by simply changing the material of the shaft the weight was reduced 2.5 times and the Young's modulus increased 1.5 times, so that the final safety factor of the silicon nitride was about 11 times that of the stainless, representing a dramatic improvement in reliability. Regarding the resonance frequency, the research results revealed the following. That is, as the shaft length decreases the resonance frequency increased geometrically, and the values for silicon nitride were double those for stainless. It was found that a structure with a short shaft in which the rotor is as light as possible is effective, and by adopting a rotating shaft of silicon nitride it is possible to increase the resonance frequency. An example of a silicon nitride rotor and shaft prepared based on these results in shown in Table 3 together with a stainless example.

EP 1 595 624 B1

Table 3

| Material | Stainless | Silicon nitride |
|---|---|---|
| Shape and size | See Figures 1-2 | |
| Rotor weight (kg) | 4.06 | 1.62 |
| Shaft diameter (cm) | 3.0 | 3.0 |
| Shaft length (cm) | 12.0 | 12.0 |
| Geometrical moment of inertia (cm$^4$) | 3.97 | 3.97 |
| Section modulus (cm$^3$) | 2.65 | 2.65 |
| Young's modulus (kgf/cm$^2$) | 2,000,000 | 3,000,000 |
| Resonance frequency | 17,440 | 33,790 |

BRIEF DESCRIPTION OF THE DRAWINGS

Figure 1 shows a conceptual drawing of a centrifugal sintering system.
Figure 2 shows the relationship (radial) between rotational frequency and safety factor for stainless and silicon nitride rotors at 800°C.
Figure 3 shows the relationship (circumferential) between rotational frequency and safety factor for stainless and silicon nitride rotors at 800°C.
Figure 4 shows the relationship between rotational frequency of a rotating shaft and safety factor of the shaft at 800°C.
Figure 5 shows measurement results of resonance frequency for different shaft lengths at 800°C.
Figure 6 shows measurement results of resonance frequency for different rotor weights at 800°C.
Figure 7 shows a conceptual drawing of an induction heating test.
Figure 8 shows results of a heating test of silicon carbides of differing electrical resistance.
Figure 9 shows an overall system diagram of a test system.

Description of numbers in the figures.

(Figure 1)
1:heating part, 2:temperature control part, 3:rotating part, 4:rotational speed control part, 5:vacuum magnetic seal bearing, 6:lid
(Figure 9)
1:Rotor and sample temperature distribution analyzer, 2:High-frequency induction heating system, 3:Rotational vibration analyzer, 4:Induction heating coil, 5:Cooling water, 6:Vibration sensor, 7:Vacuum magnetic seal bearing, 8:Infrared radiation thermometer, 9:Infrared radiation video camera, 10:Rotor, 11:Test piece adapter system, 12: Evacuation, 13:Rotation sensor, 14:High-speed spindle motor, 15:Temperature adjuster, 16:Temperature adjuster, 17:Vacuum pump, 18:Gas supply, 19:Revolution counter, 20:Inverter, 21:Centrifugal sintering system, 22:Thermocouple, 23:Coordinator

DESCRIPTION OF THE PREFERRED EMBODIMENTS

Next, the present invention is explained in detail based on examples, but the present invention is in no way limited by these examples.

Example 1

(1) Induction heating test of conductive ceramics

In the present invention, a system is adopted in which induction heating is used to heat an item to be heated by means of self heating of a rotor or sample holder member which is made of conductive material. In this case, the rotor or sample holder member needs to be not only highly conductive but also light-weight and very strong and thermally conductive. In the present example silicon carbide was selected as a material fulfilling these conditions, and the heating properties of various silicon carbide ceramic members are tested.

(2) Material properties of the test samples

Three types of test samples were prepared differing greatly in conductivity (Table 4). In particular, Sample A is a low-resistance material with the highest conductivity, while Sample C is a high-resistance material with the lowest conductivity. The samples were all prepared by the hot press method (manufacturer: Yakushima Denko). The size of the samples was 20 mm x 20 mm x 10 mmt, and the sample property values are shown in Table 4.

(3) Test methods

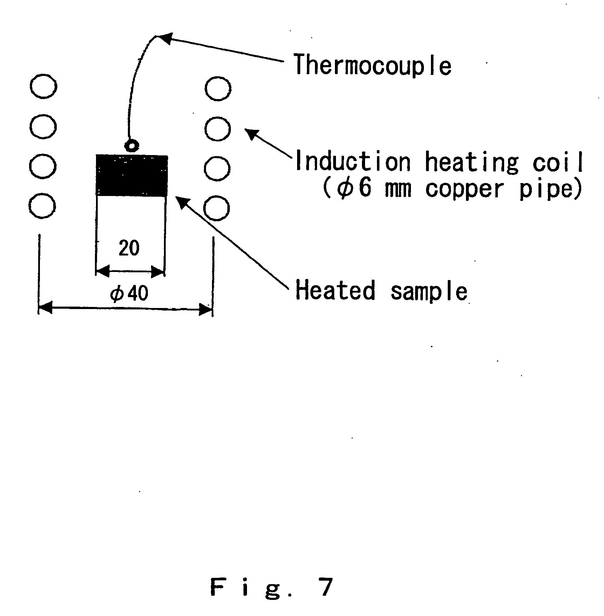

As an induction heating test (heating program test), thermocouples were attached to the sample surfaces, the output of an induction heating system (maximum output 30 kW, frequency 60-70 kHz) was controlled aiming at a standard programming rate of 200°C/min, and the surface temperature of the samples was measured by the thermocouples. An outline of the induction heating test is shown in Figure 7.

(4) Test Results

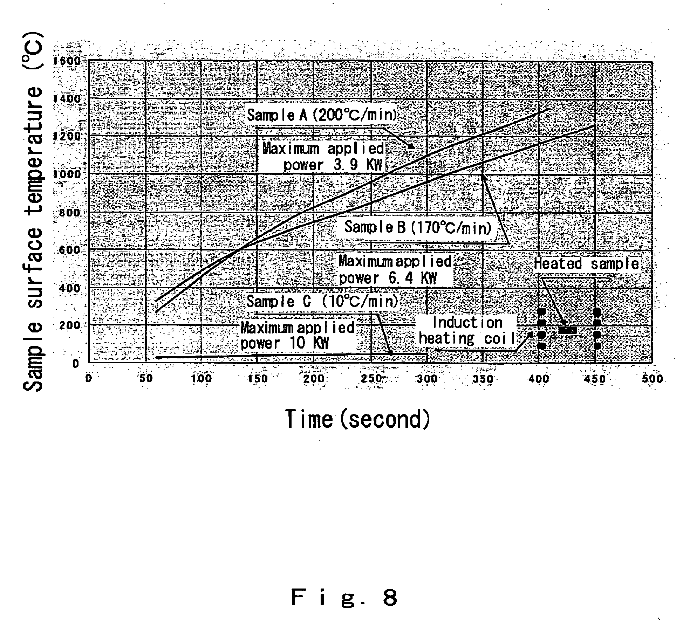

The results of the heating program test are shown in Figure 8. Elapsed time is shown on the horizontal axis and surface temperature of the sample on the vertical axis. With the low-resistance Sample A, which had the lowest electrical resistance, a programming rate of 200°C/min was achieved with a maximum power load of 3.9 kW. However, with the high-resistance Sample C, which had the highest electrical resistance, a programming rate of only 10°C/min could be achieved with a maximum power load 10 kW. This shows the strong effect of electrical resistance of the item heated.

(5) Material of the rotor or sample holder

From the above results, it appears that low-resistance silicon nitride, which has a low heating output and can be heated rapidly, is desirable as a material for the rotor or sample holder.

Example 2

A centrifugal sintering system composed of silicon carbide ceramics with a rotor and shaft of the same dimensions as those of silicon nitride shown in Table 4 was rotated at a rotational frequency of 30,000 min$^{-1}$ under conditions of heating atmospheric temperature 1200°C. As a result, there was no rotational oscillation due to thermal deformation, and high-speed operation was confirmed to occur without hindrance. It was also confirmed that as expected, oscillation began to occur at a rotational frequency of 32,000 min$^{-1}$, which is near the resonance frequency.

Table 4

| Test sample | Sample A | Sample B | Sample C |
|---|---|---|---|
| Density (g/cm$^3$) | 3.19 | 3.19 | 3.20 |
| Flexural strength (MPa) | 520 | 520 | 610 |
| Young's modulus (GPa) | 420 | 420 | 430 |
| Thermal conductivity (W/m•K) | 200 | 194 | 235 |
| Electrical resistance ($\mu\Omega$•cm) | 0.6 | 1 | 3000 |

Example 3

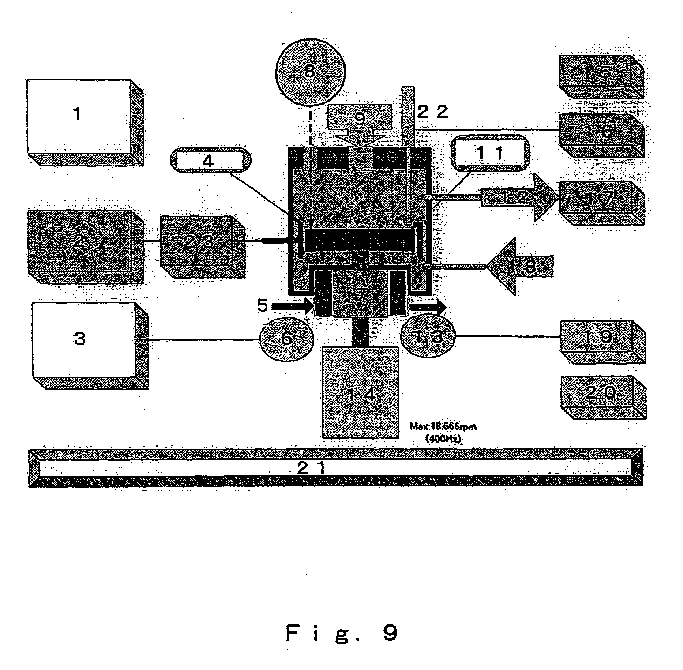

In this example, a centrifugal sintering system was used in which the high-temperature, high-speed rotating rotor containing a sample holder was composed of electrically conductive silicon carbide ceramics (the same sample material as Sample A in Example 1), and the shaft was composed of silicon nitride ceramics. The dimensions of the rotor and shaft were the same as those of silicon nitride shown in Table 3. In this system, the rotor alone was selectively caused to self heat using the induction heating coil of an induction heating system with a maximum output of 30 kw and a frequency of 70kHz with the rotor rotated at a frequency of 30,000 min$^{-1}$ to indirectly heat a sample mounted in the sample holder, at a programming rate of 800°C to a temperature of 1200°C at which it was then maintained for 2 hours. As a result, the sample holder and sample were indirectly heated to 1200°C. Unhindered operation was confirmed as a result of 3 hours of continuous operation. Figure 9 shows an overall system diagram of the system tested.

Example 4

In this example, a centrifugal sintering system was used in which the shaft and the high-temperature, high-speed rotor containing a sample holder were composed of silicon nitride ceramics and the sample holder was composed of silicon carbide ceramics. The dimensions of the rotor and shaft were the same as those of silicon nitride shown in Table 3. In this system, the sample holder alone was selectively caused to self heat using the induction heating coil of an induction heating system with a maximum output of 10 kw and a frequency of 70 kHz with the rotor rotated at a frequency of 30,000 min$^{-1}$ to indirectly heat a sample mounted in the sample holder, at a programming rate of 1200°C/hr to a temperature of 1200°C which was maintained for 2 hours. Unhindered operation was confirmed as a result of 3 hours of continuous operation.

Example 5

In this example, a centrifugal sintering system was used in which the shaft and the rotor which turned the sample holder at high temperatures and high speeds were composed of electrically insulating silicon nitride ceramics, and the sample holder was composed of silicon carbide ceramics, which is a material with a high dielectric loss. An industrial microwave heating system with an output of 5 kw was used as the dielectric heating means. A sample was mounted in the sample holder, and the sample holder alone was selectively caused to self heat by induction heating to indirectly heat the sample, at a programming rate of 1200°C/hr to a temperature of 800°C which was maintained for 1 hour. Everything apart from the use of dielectric heating as the heating means was the same as in Example 4. As a result, the sample holder and sample were indirectly heated to 800°C. Unhindered operation was confirmed as a result of 3 hours of continuous operation.

Industrial Applicability

As described above, the present invention relates to a member consisting of a rotor, shaft and sample holder for use in a centrifugal sintering system, and the following particular effects are achieved by the present invention: 1) by composing a shaft and a rotor for turning a sample holder at high temperatures and high speeds of silicon nitride or silicon carbide ceramics, it was possible to achieve a durable system which would not be thermally deformed or damaged by thermal stress even when subjected to tens of thousands of Gs of centrifugal force under atmospheric temperature conditions of 300 to 1200°C, 2) by composing a rotor for turning a sample holder at high temperatures and speeds and/or the sample holder of silicon carbide ceramics or by composing a shaft of silicon nitride ceramics it was possible to selectively heat a sample by self heating of the rotor or sample holder using induction heating means or dielectric heating means and thus achieve efficient sintering, and 3) by using a conductive silicon carbide ceramic material for at least one of the rotor and the sample holder, it was possible to selectively heat a sample and achieve highly precise and efficient sintering from the standpoint of the centrifugal sintering operation and the energy load.

**Claims**

1.   A ceramic member for a centrifugal sintering device, which is a member consisting of a rotor, a shaft and a sample holder to be used in a centrifugal sintering device imparting a centrifugal force field and a temperature field to a moulded body of ceramics or metal powder or a ceramic precursor film, wherein

(i) the rotor which turns the sample holder, the shaft and/or the sample holder are composed of ceramics;
(ii) the rotor, shaft and sample holder undergo no thermal deformation and are not damaged by thermal stress when subjected to centrifugal force of 10 to 700,000 G under conditions of atmospheric temperatures of 300 to 1200°C;
(iii) the shaft is composed of silicon nitride or silicon carbide ceramics; and
(iv) the rotor which turns said sample holder is composed of conductive silicon carbide ceramics, whereby by selectively causing only the rotor to self heat using induction heating means, a sample is heated indirectly.

2.   A ceramic member according to Claim 1, wherein said sample holder is composed of a material having a large dielectric loss, whereby by selectively heating only the sample holder using dielectric heating means, a sample is heated indirectly.

3. A ceramic member according to Claim 2, wherein said sample holder is composed of conductive silicon carbide ceramics.

4. A centrifugal sintering system comprising a ceramic member according to any one of Claims 1 to 3.

**Patentansprüche**

1. Keramikelement für eine Zentrifugal-Sintervorrichtung, wobei es sich dabei um ein Element handelt, das aus einem Rotor, einer Welle und einem Probenhalter besteht, zum Einsatz in einer Zentrifugal-Sintervorrichtung, wobei das Element auf einen Formkörper aus Keramikwerkstoffen oder Metallpulver oder einen Keramikvorläuferfilm ein Zentrifugalkraftfeld und ein Temperaturfeld überträgt, wobei:

(i) der Rotor, der den Probenhalter dreht, die Welle und/oder der Probenhalter aus Keramikwerkstoffen zusammengesetzt sind;
(ii) der Rotor, die Welle und der Probenhalter einer Wärmeverformung unterzogen und durch Wärmebeanspruchung nicht beschädigt werden, wenn sie einer Zentrifugalkraft zwischen 10 und 700.000 G bei Bedingungen von atmosphärischen Temperaturen zwischen 300 und 1.200 °C ausgesetzt werden;
(iii) die Welle aus Siliziumnitrid- und Siliziumkarbid-Keramikwerkstoffen bestehen; und
(iv) der Rotor, der den genannten Probenhalter dreht, aus leitfähigen Siliziumkarbid-Keramikwerkstoffen besteht, wobei eine Probe **dadurch** indirekt erhitzt wird, dass selektiv bewirkt wird, dass sich nur der Rotor unter Verwendung von Hochfrequenzerwärmung selbst erhitzt.

2. Keramikelement nach Anspruch 1, wobei der genannte Probenhalter aus einem Material mit einem hohen dielektrischen Verlust besteht, wobei eine Probe indirekt erhitzt wird, indem nur der Probenhalter unter Verwendung dielektrischer Erhitzung selektiv erhitzt wird.

3. Keramikelement nach Anspruch 2, wobei der genannte Probenhalter aus leitfähigen Siliziumkarbid-Keramikwerkstoffen besteht.

4. Zentrifugal-Sintersystem, das ein Keramikelement nach einem der Ansprüche 1 bis 3 umfasst.

**Revendications**

1. Élément céramique pour un dispositif de frittage centrifuge, qui est un élément consistant en un rotor, un arbre et un porte-éprouvette à utiliser dans un dispositif de frittage centrifuge communiquant un champ de force centrifuge et un champ de température à un corps moulé de céramique ou poudre métallique ou un film précurseur de céramique, dans lequel :

(i) le rotor qui tourne le porte-éprouvette, l'arbre et/ou le porte-éprouvette sont composés de céramique ;
(ii) le rotor, l'arbre et le porte-éprouvette ne subissent aucune déformation thermique et ne sont pas endommagés par la contrainte thermique lorsqu'ils sont soumis à une force centrifuge de 10 à 700 000 G dans des conditions de températures atmosphériques de 300 à 1200 °C ;
(iii) l'arbre est composé de céramique de nitrure de silicium ou de carbure de silicium ; et
(iv) le rotor qui tourne ledit porte-éprouvette est composé de céramique de carbure de silicium conductrice, moyennant quoi en amenant sélectivement uniquement le rotor à s'échauffer en utilisant des moyens de chauffage par induction, une éprouvette est chauffée indirectement.

2. Élément céramique selon la revendication 1, dans lequel ledit porte-éprouvette est composé d'un matériau ayant une grande perte diélectrique, moyennant quoi en chauffant sélectivement uniquement le porté-éprouvette en utilisant des moyens de chauffage diélectriques, une éprouvette est chauffée indirectement.

3. Élément céramique selon la revendication 2, dans lequel ledit porte-éprouvette est composé de céramique de carbure de silicium conductrice.

4. Système de frittage centrifuge comprenant un élément céramique selon l'une quelconque des revendications 1 à 3.

Fig. 1

F i g. 2

F i g. 3

F i g. 4

F i g. 5

F i g. 6

Thermocouple

Induction heating coil
($\phi$6 mm copper pipe)

Heated sample

20

$\phi$40

F i g. 7

F i g. 8

Max.18.666rpm
(400Hz)

F i g. 9

**EP 1 595 624 B1**

**REFERENCES CITED IN THE DESCRIPTION**

**Patent documents cited in the description**

- JP 20021936802002 B
- EP 1219580 A